# EUROPÄISCHE PATENTSCHRIFT

(11) **EP 0 709 920 B1**
(45) Veröffentlichungstag und Bekanntmachung des Hinweises auf die Patenterteilung: **18.11.1998**
(21) Anmeldenummer: 95113952.6
(22) Anmeldetag: 06.09.1995
(51) Int. Cl.: H01R 9/26, H01R 25/14, H01R 9/09

(54) **Modulare Steuerungsanlage**
Modular control system
Système de commande modulaire

(30) Priorität: 31.10.1994 DE 4438801
(43) Veröffentlichungstag der Anmeldung: 01.05.1996
(73) Patentinhaber: Weidmüller Interface GmbH & Co., D-32760 Detmold (DE)
(72) Erfinder: Dux, Dietmar, D-32758 Detmold (DE); Hanning, Walter, D-32758 Detmold (DE); Fiene, Uwe, D-32839 Steinheim (DE); Schnatwinkel, Michael, D-32051 Herford (DE); Steinmeier, Rudolf, D-32760 Detmold (DE); Wilmes, Manfred, D-32760 Detmold (DE); Hamann, Christian, D-37603 Holzminden (DE); Hettwer, Thomas, D-32756 Detmold (DE); Zebermann, Christoph, Dr., D-37688 Beverungen (DE); Glathe, Hans-Georg, D-32758 Detmold (DE)
(74) Vertreter: Stracke, Alexander, Dipl.-Ing.

(56) Entgegenhaltungen:
- DE-A- 1 512 024
- DE-A- 1 512 045
- DE-U- 1 669 436
- US-A- 5 291 179

## Beschreibung

Die Erfindung betrifft eine modulare Steuerungsanlage, insbesondere für elektronische Steuerungs- und Automatisierungssysteme, mit anreihbaren Gehäuseblocks, in denen jeweils Busleiterabschnitte eines internen Busleiters angeordnet sind, mit verschiebbaren Kontaktierstücken zum elektrischen Verbinden der Busleiterabschnitte benachbarter Gehäuseblocks und mit Elektronikmodulen, die mit den Gehäuseblocks mechanisch und den Busleiterabschnitten elektrisch leitend steckverbindbar sind. Bei einer derartigen bekannten Steuerungsanlage (DE 41 40 611 C1) können die einzelnen Elektronikmodule aus der Anreihung heraus abgenommen werden, ohne daß der interne Busleiter in seiner Gesamtheit an dieser Stelle unterbrochen wird, da der Gehäuseblock des betroffenen Elektronikmoduls in der Anreihung verbleiben kann und die Kontaktierstücke die leitende Verbindung der betroffenen Busleiterabschnitte benachbarter Gehäuseblocks aufrechterhalten. Die so aufgebaute Steuerungsanlage ist auch mit diesen Bauelementengruppen ergänzbar und erweiterbar. Bei der bekannten Steuerungsanlage ist das Kontaktierstück ein Dreipunktkontaktierer, der etwa winkelförmig ausgebildet ist und in dem an dessen offener Unterseite nebeneinander Kontaktfedern entsprechend der Anzahl der Leiterbahnen in der Oberseite der Busleiterabschnitte vorgesehen sind. In dem nach oben weisenden Winkel des Dreipunktkontaktierers befinden sich die Steckanschlüsse zur Kontaktierung der Funktionsleiterplatte im Elektronikmodul. Bei dieser Ausgestaltung ist die zu verwirklichende Anzahl möglicher Leiterbahnen im internen Busleiter begrenzt, bzw. führt eine hohe Anzahl von Leiterbahnen zu einer beträchtlichen Baubreite.

Soll ferner auch ein Gehäuseblock aus der Anreihung ausgebaut werden, muß neben dem betroffenen Elektronikmodul mindestens noch ein angrenzender Elektronikmodul abgenommen werden, um die beiden betroffenen Kontaktierstücke so verlagern zu können, daß der Gehäuseblock aus der Anreihung herausgenommen werden kann. Die Montage dieser Kontaktierstücke bei der Errichtung, der Erweiterung oder dem Umbau einer derartigen Steueranlage ist nicht handhabungsbequem, da diese Kontaktierstücke zur Erzeugung des Kontaktfederdruckes in enge Führungen angrenzender Gehäuseteile eingezwängt werden müssen und es sich im übrigen um lose Einzelbauelemente handelt, die für sich genommen bevorratet und transportiert werden müssen und die ferner verlorengehen können.

Es sind ferner modulare Steuerungsanlagen bekannt, die aus steckbaren Elektronikmodulen und Anschlußmodulen zusammensetzbar sind, wobei die Anschlußmodule Versorgungsleiter- und Signalleiteranschlüsse aufweisen und aus einzelnen Anschlußscheiben zusammengesetzt sind (DE 43 03 717 A1). Durch entsprechende Formgestalt der einzelnen Anschlußscheiben bilden die modularen Anschlußblocks auch eine Aufnahmezone für einen internen Busleiter. Nicht dargestellt und nicht beschrieben ist, wie die Busverbindung der einzelnen Anschlußscheiben und der einzelnen Anschlußblocks zu realisieren ist.

Die FR 2 247 836 zeigt einen Verbinder für Stromschienen eines Trag- und Stromverteilersystems für Lampen und sonstige Verbraucher, der aus isoliert übereinander in einem Gehäuse angeordneten, seitlich vorstehenden Kontaktblechen und drahtförmigen Hilfskontakten besteht und der in zwei zu verbindende Stromschienenabschnitte eingeschoben wird. Ein beidseitig auf diese Weise verbundener Stromschienenabschnitt kann zwischen fest angeordneten Nachbarschienenabschnitten herausgenommen werden, indem die Verbinder vollständig in einen Stromschienenabschnitt eingeschoben werden. Eine zuverlässige Kontaktierung erfordert eine exakt abgestimmte Dimensionierung der Verbinder und der damit zusammenwirkenden Stromschienenbereiche.

Der vorliegenden Erfindung liegt die Aufgabe zugrunde, eine modulare Steuerungsanlage der gattungsgemäßen Art zu schaffen, die die Nutzung einer hohen Anzahl von Leiterbahnen des internen Busleiters platzsparend ermöglicht und deren Montage, Umrüstung und/oder Erweiterung bezüglich der Kontaktierstücke zur Verbindung der internen Busleiterabschnitte benachbarter Gehäuseblocks in deren Anreihung besonders einfach und handhabungsbequem ist.

Die erfindungsgemäße Lösung besteht im wesentlichen darin, daß die Kontaktierstücke selbsttragend in sich geschlossene Trennschieber mit oberen und unteren Kontaktfedern für Leiterbahnen auf der Ober- und Unterseite der Busleiterabschnitte sind, die zwischen einer die einander zugewandten Enden der Busleiterabschnitte benachbarter Gehäuseblocks umgreifenden Kontaktstellung und einer nur einen Busleiterabschnitt erfassenden Trennstellung verschiebbar sind.

Mit einer solchen Ausgestaltung läßt sich eine Vielzahl von Leiterbahnen des internen Busleiters auf engem Raum verwirklichen und bezüglich der Busleiterabschnitte benachbarter angereihter Gehäuseblocks über einen derartigen Trennschieber miteinander verbinden, da die Busleiterabschnitte oberseitig und unterseitig genutzt werden können. Der selbsttragend in sich geschlossene Trennschieber ermöglicht dabei die Einsetzung oberer und unterer Kontaktfedern, deren Kontaktfederkraft durch entsprechende Wandungen des selbsttragenden in sich geschlossenen Trennschiebers selbst erzeugt wird, so daß ein solcher Trennschieber sich auf den Busleiterabschnitten selbst hält und auch führen kann, so daß an eine zusätzliche Führung in den Gehäuseblocks keine besonderen Anforderungen zu stellen sind. Die Montage und die Verschiebung derartiger Trennschieber sind außerordentlich einfach und handhabungsbequem, da insbesondere nicht die Federkontaktkraft durch spezielle Stützungen des Kontaktierstückes an angrenzenden Bereichen der Gehäuseblocks erfolgen muß. Dank dieser Ausgestaltung lassen sich problemlos die Trennschieber auch jeweils einem derartigen Gehäuseblock herstellerseitig integral zuordnen, so daß es sich nicht um Einzelmontageelemente handelt, was Bevorratung und Transport vereinfacht und zur hohen Handhabungsbequemlichkeit beim Anwender beiträgt.

In zweckmäßiger Ausgestaltung sind die Kontaktierstellung und die Trennstellung der Trennschieber verrastbar ausgebildet. Für die Trennstellung hat das den Vorteil, daß für den Transport und Lagerhaltung die Trennschieber in dem zugeordneten Gehäuseblock eine gesicherte eingeschobene Lage haben. Für die Kontaktierstellung bedeutet dies, daß die Kontaktierstellung gegenüber Vibrationsbelastungen sowie gegenüber der Schwerkraft bei entsprechender schräger oder senkrechter Anordnungslage in der Steuerungsanlage gesichert ist.

In weiterer zweckmäßiger Ausgestaltung sind auch die Busleiterabschnitte in ihrer Montagelage in den jeweiligen Gehäuseblocks verrastet, so daß sie sich bei Vibrationsbelastung und unter Schwerkraft bei entsprechender Anordnung der Steuerungsanlage sowie bei Betätigung der Trennschieber nicht verlagern kann.

In weiterer zweckmäßiger Ausgestaltung bilden die Gehäuseblocks einen Teilbereich modularer, anreihbarer Anschlußblocks, die Versorgungsleiter- und Signalleiteranschlüsse aufweisen und aus einzelnen Anschlußscheiben zusammengesetzt sind. Abgesehen davon, daß eine so aufgebaute Steuerungsanlage in der Ausgestaltung außerordentlich flexibel ist, können dadurch, daß die gehäuseseitigen Aufnahmekonturen für die Busleiterabschnitte und die Trennschieber aus entsprechender Konturierung der einzelnen Anschlußscheiben des Blocks gebildet sind, die Verrastung für die Trennschieber und die Busleiterabschnitte einfach und variabel ausgebildet werden.

Ein Ausführungsbeispiel einer derartigen Steuerungsanlage wird nachfolgend unter Bezugnahme auf die Zeichnungen näher beschrieben.
Es zeigen
- Figur 1: eine perspektivische Darstellung eines Teiles einer modularen Steuerungsanlage gemäß der Erfindung,
- Figur 2: in perspektivischer Einzelansicht einen Busleiterabschnitt eines Gehäuseblockes der Steuerungsanlage nach Figur 1 mit darauf angeordnetem Trennschieber,
- Figuren 3 und 4: den in Teilschnittdarstellung gezeigten Trennschieber in seiner nur einen Busleiterabschnitt erfassenden Trennstellung und in seiner die zugewandten benachbarten Enden zweier Busleiterabschnitte erfassenden Kontaktierstellung,
- Figur 5: eine perspektivische, teilweise gebrochene Darstellung des Gehäuseblockbereiches eines aus Einzelscheiben aufgebauten Anschlußblocks mit eingesetztem Busleiterabschnitt und darauf angeordnetem Trennschieber.

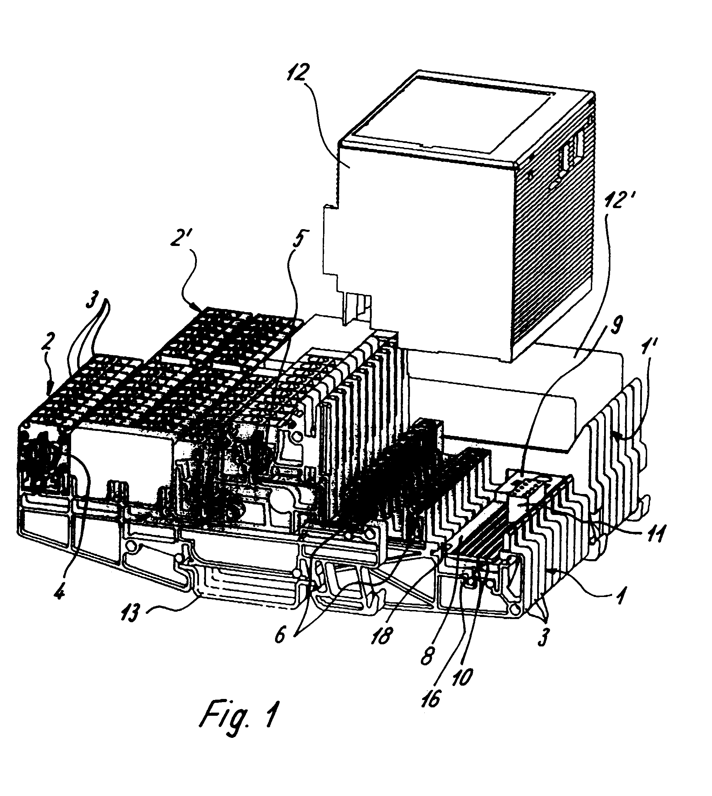

Die in ihrem grundsätzlichen Aufbau in Figur 1 illustrierte modulare Steuerungsanlage, insbesondere für elektronische Steuerungs- und Automatisierungssysteme, beinhaltet Gehäuseblocks 1, die in diesem Ausführungsbeispiel Teilbereich von Anschlußblocks 2 sind, die, einschließlich des Gehäusebereiches, aus einzelnen Anschlußscheiben 3 zu Blocks der jeweils gewünschten Größe zusammengesetzt sind. In den Anschlußscheiben 3 befinden sich jeweils Versorgungsleiteranschlüsse 4 einschließlich Schutz-/Schirmleiteranschlüsse zum Anschließen von Initiatoren, Sensoren, Feldgeräten und dergleichen sowie Signalleiteranschlüsse 5, die elektrisch leitende Verbindungen zu Steckanschlüssen 6 aufweisen. Im Bereich des ebenfalls durch die Anschlußscheiben 3 in ihrer Anreihung gebildeten Gehäuseblocks 1 der Anschlußblöcke 2 ist jeweils ein Busleiterabschnitt 8 angordnet, wobei die Busleiterabschnitte 8 benachbarter angereihter Anschlußblocks 2, jeweils über noch im einzelnen zu beschreibende Trennschieber 9 elektrisch leitend miteinander verbindbar, einen internen Busleiter einer aus den genannten Elementen aufgebauten Steuerungsanlage bilden. Auf den Busleiterabschnitten 8 sitzen ferner, elektrisch leitend mit Leiterbahnen 10 der Busleiterabschnitte 8 verbunden, Steckverbinder 11. Mit der geschilderten Anordnung sind als weitere Elemente derartiger modularer Steuerungsanlagen Elektronikmodule 12 steckverbindbar, und zwar deren im Inneren der Modulgehäuse angeordneten Funktionsleiterplatten elektrisch leitend mit den Steckanschlüssen 6 der Anschlußblocks 2 und den Steckverbindern 11 und deren Gehäuse mechanisch verrastend mit entsprechenden gegenüberliegenden Gehäusebereichen der Anschlußblocks 2.

An dem einen Ende einer derartigen modular aufgebauten Steuerungsanlage kann sich ferner, wie in diesem Ausführungsbeispiel dargestellt, ein Anschlußblock 2' mit entsprechendem Gehäuse block 1' befinden, mit dem ein Elektronikmodul 12' zur Kopplung des internen, aus den Busleiterabschnitten 8 aufgebauten Busleiters mit einem externen Feldbus steckverbindbar ist. Zur elektrischen Verbindung bzw. auch Trennung des Busleiterabschnittes 8 des an diesem Gehäuseblock 1' angrenzenden Anschlußblocks 2 mit einem entsprechenden Busleiterabschnitt in diesem Gehäuseblock 1' für den Elektronikmodul 12' dient ebenfalls ein derartiger Trennschieber 9.

Abweichend vom hier beschriebenen Ausführungsbeispiel können derartige Elektronikmodule 12, 12' auch auf einstückig ausgebildete anreihbare Gehäuseblocks aufgesteckt werden, in denen dann jeweils Busleiterabschnitte 8 zur Bildung eines internen Busleiters der modularen Steuerungsanlage angeordnet sind.

Die anreihbaren Anschlußblocks 2 bzw. die genannten einstückigen anreihbaren Gehäuseblocks werden üblicherweise nebeneinander auf Tragschienen 13 aufgerastet.

Die Busleiterabschnitte 8 sind oberseitig und unterseitig mit Leiterbahnen 10 versehen, so daß platzsparend viele Leiterbahnen benutzt werden können. Die Trennschieber 9 zur elektrischen Kontaktierung oder elektrischen Trennung der einander zugewandt liegenden Enden der Busleiterabschnitte 8 in der Anreihung aneinandergrenzender Gehäuseblocks 1 von Anschlußblocks 2 oder Gehäuseblocks 1' sind selbsttragend in sich geschlossen ausgebildet und haben einen Abschnitt mit geschlossener Gehäusekontur, der jeweils von verschmälerten Endabschnitten 8a der Busleiterabschnitte 8 durchtreten werden kann. In dem Gehäuse 14 der Trennschieber 9 sind jeweils nebeneinanderliegend obere und untere Kontaktfedern 15 angeordnet, und zwar zu beiden Seiten der Durchtrittszone der Endabschnitte 8a der Busleiterabschnitte 8. Die Anzahl der oberen und unteren Kontaktfedern 15 entspricht der Anzahl der oberen und unteren Leiterbahnen 10 der Busleiterabschnitte 8. Die Anordnung der Kontaktfedern 15 in dem Gehäuse 14 mit geschlossener Gehäusekontur bewirkt im Sinne der selbsttragenden Bauweise der Trennschieber 9, daß die Trennschieber 9 jeweils für sich genommen durch Abstützung der Kontaktfedern 15 an Abschnitten des Gehäuses 14 die Kontaktfederkraft erzeugen. Hierdurch sind die Trennschieber 9 auch im wesentlichen selbsthaltend auf den umgriffenen Busleiterabschnitten 8a, auch mit einer gewissen Führung darauf, verschieblich angeordnet.

Darüber hinaus werden zweckmäßig die Trennschieber 9 auch noch in angrenzenden Bereichen der Gehäuseblocks 1, 1' verschieblich geführt, wozu im dargestellten Ausführungsbeispiel die Anschlußscheiben 3 der Anschlußblocks 2 so konturiert sind, daß sie in ihrer Aneinanderreihung innerhalb des Blocks eine unterhalb der Aufnahme für die Busleiterabschnitte 8 liegende Führungsnut 16 definieren und die Trennschieber auf der Unterseite des Gehäuses 14 Führungsstege 17 aufweisen, die in den Führungsnuten 16 geführt werden. Es ist ferner eine Führung der seitlichen Wände des Gehäuses 14 an den daran angrenzenden Wandungsabschnitten 18 des Bereiches des Gehäuseblocks 1 der Anschlußblöcke 2 möglich.

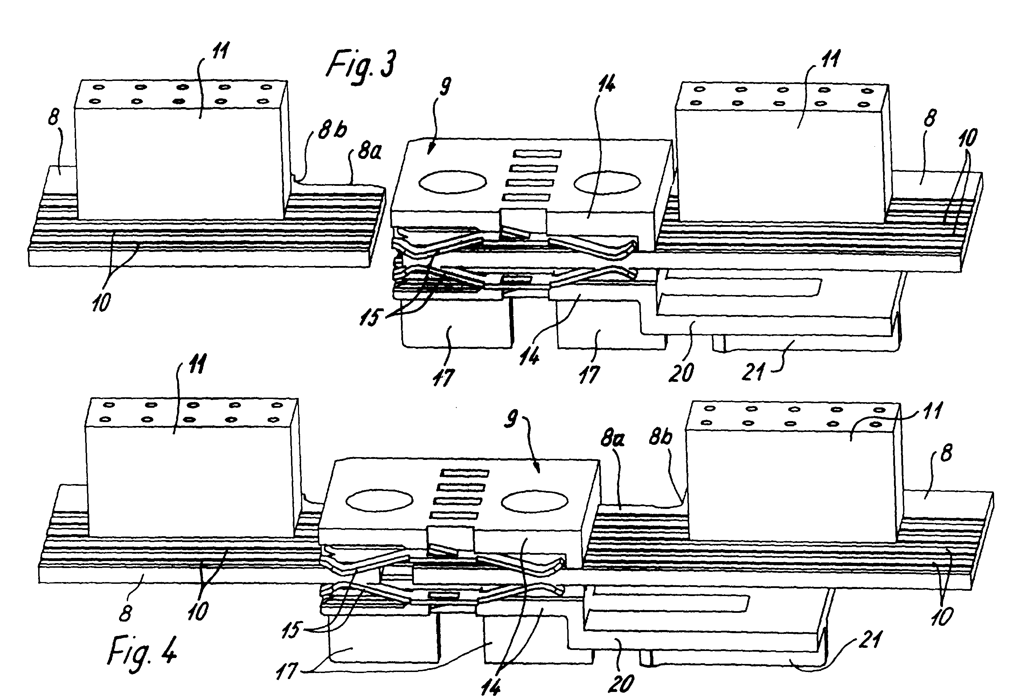

Bei der Montage und/oder Erweiterung derartiger modularer Steuerungsanlagen werden zur Bildung des internen Busleiters der Steuerungsanlage die Busleiterabschnitte 8 in der Anreihung benachbart liegender Anschlußblöcke 2 bzw. Gehäuseblöcke 1, 1' elektrisch leitend mittels der Trennschieber 9 verbunden, die hierzu in die vorgeschobene Kontaktierstellung (Figur 4) verschoben werden, in der sie aus dem ihnen jeweils zugeordneten Gehäuseblock 1 in den Gehäuseblock 1, 1' des angrenzenden Anschlußblockes 2, 2' vorstehen, der naturgemäß eine entsprechende Eintrittsöffnung aufweist und in der sie jeweils mit den einen entsprechenden Enden ihrer oberen und unteren Kontaktfedern 15 dann die Leiterbahnen 10 des Busabschnittes 8 in dem angrenzenden Block kontaktieren.

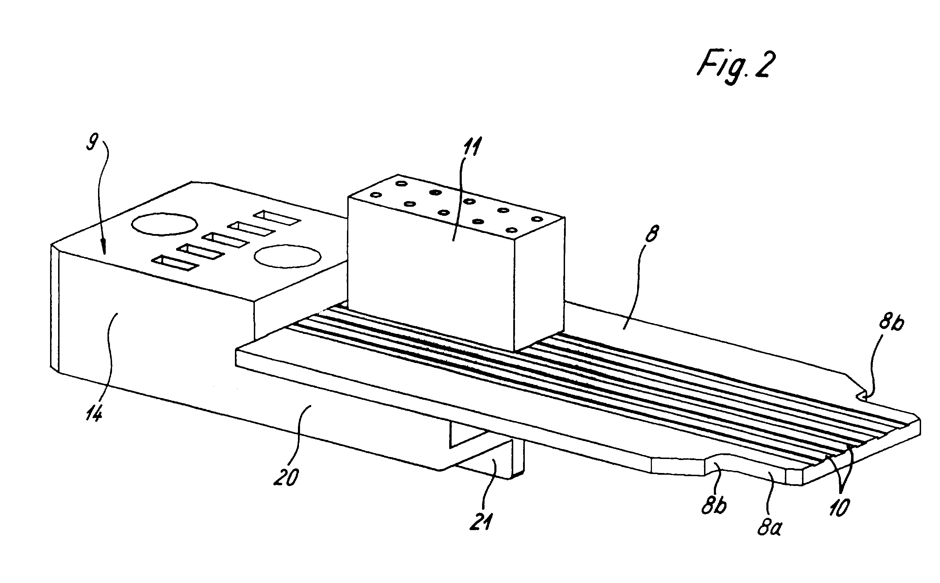

Die Elektronikmodule 12, 12' sind unterseitig so konturiert, insbesondere zum Bereich der Busleiterabschnitte 8 und der Trennschieber 9 hin so offen, daß aus einer Anreihung heraus beispielsweise ein Elektronikmodul 12 problemlos von dem betroffenen Anschlußblock 2 abgenommen werden kann, wobei die elektrische Kontaktierung des internen Busleiterabschnittes 8 dieses Anschlußblockes über die beiden dann mit ihm zusammenwirkenden Trennschieber 9 aufrechterhalten bleibt. Soll bei Umrüstung oder Auswechslung ein Anschlußblock 2 in seiner Gesamtheit aus der Anreihung ausgebaut werden, wird zunächst wieder der Elektronikmodul 12 abgenommen. Der eine diesem Anschlußblock 2 zugeordnete Trennschieber 9 wird in die Trennstellung zurückgeschoben, wie aus Figur 2 ersichtlich. Der Trennschieber 9 umfaßt dann nur noch den Endabschnitt 8a dieses Busleiterabschnittes 8 dieses Blocks und kommt dabei völlig aus dem angrenzenden Block frei. Der andere Trennschieber 9 wird von dem hier betroffenen Busleiterabschnitt 8 des zu entnehmenden Blocks in den angrenzenden Block vollständig eingeschoben, so daß dann auch dieser Trennschieber in der Trennstellung liegt.

Der betroffene Anschlußblock 2 kann dann insgesamt aus der Anreihung heraus durch Abrastung von der Tragschiene 13 abgenommen werden.

Die Trennstellung und die Kontaktierstellung der Trennschieber 9 werden zweckmäßig verrastet. Die Kontaktierstellung wird dadurch gegenbüber Rüttelbelastungen oder Schwerkraftbelastung bei entsprechend schräger oder senkrechter Raumlage des Trennschiebers 9 gesichert. Die Trennstellung wird dadurch bei Transport und Lagerhaltung gesichert, wobei dank der geschilderten Bauweise schon herstellerseitig jeweils ein Trennschieber 9 durch Anordnung auf dem integrierten Busleiterabschnitt 8 einem modularen Block zugeordnet werden kann.

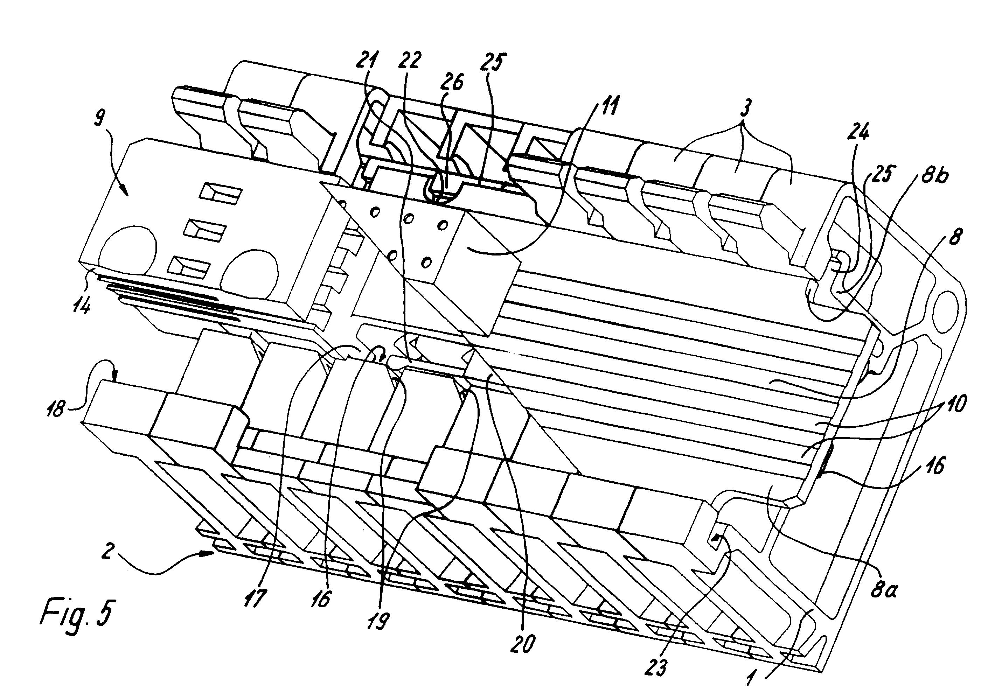

Im dargestellten Ausführungsbeispiel wird die genannte Verrastung auf baulich einfache und in Anpassung an mögliche unterschiedliche Blockgrößen entsprechend der Anzahl der verwendeten Anschlußscheiben 3 dadurch errreicht, daß sämtliche Anschlußscheiben 3 der Anschlußblöcke 2 in einem der Seitenwandungsabschnitte, die die Führungsnut 16 bilden, jeweils an einer Seite eine Rastausklinkung 19 aufweisen (Figur 5). An den Trennschiebern 9 befindet sich an dem Gehäuse 14 an einem rückwärtigen Ansatz 20 unterseitig eine etwa fluchtend zu den Führungsstegen 17 orientierte Rastfeder 21. Die Rastfeder 21 kann mit ihrem Rastkopf sowohl in der Kontaktierstellung wie auch in der Trennstellung immer in eine dann bereitliegende Rastausklinkung 19 einrasten. Die Trenn- und Kontaktierstellungen der Trennschieber 9 werden im übrigen durch Schultern 8b definiert, die sich im Übergangsbereich zwischen den verschmälerten Endabschnitten 8a und den Busleiterabschnitten 8 im übrigen bilden.

Die Führungsstege 17 ergeben auch in Verbindung mit der fluchtend zu ihnen liegenden Rastfeder 21 einen hohen Verkantungsschutz für die Schiebebewegung der Trennschieber 9. Dazu trägt auch die Verlängerung der Seitenwandungen des Gehäuses 14 der Trennschieber 9 durch den Ansatz 20 am Gehäuse 14 bei, dessen Breite der Breite des Gehäuses 14 entspricht, so daß auch hier noch eine Führung an den Wandabschnitten 18 des Bereiches des Gehäuseblockes 1 der Anschlußblöcke 2 erfolgt.

Die Rastfeder 21 der Trennschieber 9 besteht zweckmäßig aus einem Abschnitt vergleichbar den Führungsstegen 17 und einem damit in Verbindung stehenden, schmaleren und frei beweglichen Federabschnitt, der den Rastkopf trägt.

In weiterer zweckmäßiger Ausgestaltung wird auch die ordnungsgemäße Position des integrierten Busleiterabschnittes 8 im Gehäuseblock 1, 1' der Anschlußblöcke 2, 2' durch Verrastung fixiert, um zu verhindern, daß sich der Busleiterabschnitt 8 im Gehäuseblock 1, 1' durch Rüttelbelastung, Schwerkraft und/oder durch Betätigung der Trennschieber 9 verlagert. Im dargestellten Ausführungsbeispiel (Figur 5) haben die Busleiterabschnitte 8 an einer vorgegebenen Stelle eine seitliche Rastausklinkung 22. Die Anschlußscheiben 3 der Anschlußblöcke 2 sind im Bereich des Gehäuseblocks 1 so konturiert, daß sie beidseitig in der Aufnahmezone in ihrer Anreihung Steck- und Aufnahmenuten 23, 24 bilden, in die die Busleiterabschnitte 8 mit ihren seitlichen Randbereichen eingesteckt werden können. Die Steck- und Aufnahmenut 24 wird dabei durch an das Gehäuse der Anschlußscheiben 3 im übrigen emporstehend angeformte Federstege 25 unten und seitlich begrenzt, wobei in der seitlichen Begrenzung der Federstege 25 in jeder Anschlußscheibe 3 ein kleiner vorspringender Rastkopf 26 vorgesehen ist.

Die Dimensionierung ist so getroffen, daß der Busleiterabschnitt 8 unter leicht federnder Auslenkung der Federstege 25 in den Steck- und Aufnahmenuten 23, 24 liegt. In der gewünschten Position kann dann einer der Rastköpfe 26 der aneinandergereihten Federstege 25 in die Rastausklinkung 22 des Busleiterabschnittes 8 einrasten, wie in Figur 5 dargestellt.

Abweichend von dem hier beschriebenen Ausführungsbeispiel können derartige Elektronikmodule auch einscheibig aufgebaut sein und auf einzelne Anschlußscheiben 3, die zu Gehäuseblocks angereiht werden, aufgesteckt werden, wobei dann auch der Steckverbinder 11 im Scheibenraster aufgebaut ist und die Funktionsleiterplatte mit einer durchgehenden Busleiterplatte 8 verbindet.

## Patentansprüche

1. Modulare Steuerungsanlage, insbesondere elektronische Steuerungs- und Automatisierungssysteme, mit anreihbaren Gehäuseblocks (1, 1'), in denen jeweils Busleiterabschnitte (8) eines internen Busleiters angeordnet sind, mit verschiebbaren Kontaktierstücken (9) zum elektrischen Verbinden der Busleiterabschnitte (8) benachbarter Gehäuseblocks (1, 1') und mit Elektronikmodulen (12, 12'), die mit den Gehäuseblocks (1, 1') mechanisch und den Busleiterabschnitten (8) elektrisch leitend steckverbindbar sind, **dadurch gekennzeichnet**, daß die Kontaktierstücke selbsttragend in sich geschlossene Trennschieber (9) mit oberen und unteren Kontaktfedern (15) für Leiterbahnen (10) auf der Ober- und Unterseite der Busleiterabschnitte (8) sind, die zwischen einer die einander zugewandten Endabschnitte (8a) der Busleiterabschnitte (8) benachbarter Gehäuseblocks (1, 1') umgreifender Kontaktierstellung und einer nur einen Busleiterabschnitt (8) erfassender Trennstellung verschiebbar sind.

2. Modulare Steuerungsanlage nach Anspruch 1, dadurch gekennzeichnet, daß die Kontaktierstellung und die Trennstellung der Trennschieber (9) verrastet sind.

3. Modulare Steuerungsanlage nach Anspruch 1 oder 2, dadurch gekennzeichnet, daß die Busleiterabschnitte (8) in ihrer Montagelage in den Gehäuseblocks (1, 1') verrastet sind.

4. Modulare Steuerungsanlage nach einem der vorhergehenden Ansprüche, dadurch gekennzeichnet, daß die Gehäuseblocks (1, 1') einen Teilbereich von modularen, anreihbaren Anschlußblocks (2, 2') bilden, die Versorgungsleiter- und Signalleiteranschlüsse (4 und 5) aufweisen und aus einzelnen Anschlußscheiben (3) zusammengesetzt sind.

5. Modulare Steuerungsanlage nach einem der vorhergehenden Ansprüche, dadurch gekennzeichnet, daß die Trennschieber (9) ein Gehäuse (14) in geschlossener Querschnittskontur haben, in der ein Durchtritt für die Endabschnitte (8a) der Busleiterabschnitte (8) gebildet ist, angrenzend an den oberseitig und unterseitig die Kontaktfedern (15), im Gehäuse (14) abgestützt, angeordnet sind.

6. Modulare Steuerungsanlage nach einem der vorhergehenden Ansprüche, dadurch gekennzeichnet, daß die Seitenwände des Gehäuses (14) der Trennschieber (9) an angrenzenden Wandungsabschnitten (18) der Gehäuseblocks (1, 1'), die gegebenenfalls durch Einzelwandungsabschnitte der aneinandergereihten Anschlußscheiben (3) der Anschlußblocks (2) gebildet werden, geführt sind.

7. Modulare Steuerungsanlage nach einem der vorhergehenden Ansprüche, dadurch gekennzeichnet, daß auf der Unterseite der Gehäuse (14) der Trennschieber (9) vorspringende Führungsstege (17) vorgesehen sind, für die in den Gehäuseblocks (1, 1') Führungsnuten (16) gebildet sind, die gegebenenfalls durch Führungsnutenabschnitte der zusammengesetzten Anschlußscheiben (3) der Anschlußblocks (2) gebildet sind.

8. Modulare Steuerungsanlage nach den Ansprüche 2 und 4, dadurch gekennzeichnet, daß an den Trennschiebern (9) eine in Verschieberichtung orientierte Rastfeder (21) mit einem Rastkopf vorgesehen ist und daß die Anschlußscheiben (3) der Anschlußblöcke (2) in ihrem an die Rastfeder (21) angrenzenden Wandungsbereich jeweils eine Rastausklinkung (19) für den Rastkopf aufweisen.

9. Modulare Steuerungsanlage nach Anspruch 8, dadurch gekennzeichnet, daß an dem Trennschiebergehäuse (14) ein rückwärtiger Ansatz (20) vorgesehen ist, auf dessen Unterseite die Rastfeder (21) vorgesehen ist, die in Fluchtungslage zu den Führungsstegen (17) auf der Unterseite des Gehäuses (14) liegt.

10. Modulare Steuerungsanlage nach Anspruch 8, dadurch gekennzeichnet, daß die Rastfeder (21) neben einem federnd wirkenden Abschnitt einen im wesentlichen den Führungsstegen (17) entsprechenden Abschnitt hat.

11. Modulare Steuerungsanlage nach Anspruch 9, dadurch gekennzeichnet, daß der Ansatz (20) des Gehäuses (14) als zusätzliches Führungselement ausgebildet ist und die gleiche Seitenabmessung wie das Gehäuse (14) hat.

12. Modulare Steuerungsanlage nach einem der vorhergehenden Ansprüche, dadurch gekennzeichnet, daß in dem Gehäuseblock (1, 1') der Anschlußblocks (2, 2') eine Aufnahme für den Busleiterabschnitt (8) gebildet ist, die aus einander gegenüberliegenden seitlichen Steck- und Aufnahmenuten (23, 24) besteht, die gegebenenfalls durch die Aneinanderreihung entsprechender Steck- und Aufnahmenutabschnitte der zusammengesetzten Anschlußscheiben (3) der Anschlußblocks (2) gebildet ist.

13. Modulare Steuerungsanlage nach den Ansprüchen 3, 4 und 12, dadurch gekennzeichnet, daß die eine Steck- und Aufnahmenut (24) teilweise durch an den Anschlußscheiben (3) der Anschlußblocks (2) gebildete Federstege (25) gebildet ist, die jeder im Bereich der seitlichen Begrenzung der Nut (24) einen Rastkopf (26) aufweisen, wobei in der betroffenen Seite des Busleiterabschnittes (8) an vorgegebener Stelle eine Rastausklinkung (22) zum Zusammenwirken mit dem Rastkopf eines der Federstege (25) gebildet ist.

14. Modulare Steuerungsanlage nach einem der vorhergehenden Ansprüche, dadurch gekennzeichnet, daß die Busleiterabschnitte (8) verschmälerte Endbereiche (8a) aufweisen, auf denen die Trennschieber (9) verschieblich angeordnet sind, wobei der Übergang von verschmälertem Endabschnitt (8a) zum Busleiterabschnitt (8) im übrigen eine Schulter (8b) bildet, die die Trennstellung/Kontaktierstellung der Trennschieber (9) definiert.

## Claims

1. Modular Control equipment, in particular electronic control and automation systems, with attachable frame blocks (1, 1'), in of each which bus conductor sections (8) of an internal bus conductor are arranged, with moveable contact pieces (9) for electrical connection of the frame blocks (1, 1') adjacent to the bus conductor sections (8), and with electronics modules (12, 12') which are pluggable mechanically into the frame blocks (1, 1') and electroconductively into the bus conductor sections, characterised in that the contact pieces are self-supporting, self-contained, separators (9) with upper and lower contact springs (15) for conductor lines (10) on the upper and lower sides of the bus conductor sections (8), movable between a contacting position extending between one and the other of the facing end sections (8a) of the frame blocks (1, 1') adjacent to the bus conductor sections (8), and a separating position engaging only one bus conductor section (8).

2. Modular control equipment according to claim 1, characterised in that the contacting position and the separating position of the separator (9) are latched.

3. Modular control equipment according to claim 1 or 2, characterised in that the bus conductor sections (8) are latched into their mounted position in the frame block (1, 1').

4. Modular control equipment according to one of the preceding claims, characterised in that the frame blocks (1, 1') form part of an area of modular, attachable, terminal blocks (2, 2') which are provided with supply line and signal line terminals (4 and 5) and comprise individual connectors (3).

5. Modular control equipment according to one of the preceding claims, characterised in that the separators (9) have a frame (14) with an enclosed cross-section profile in which a through-passage for the end sections (8a) of the bus conductor sections (8) is configured, adjacent to which, on the upper side and lower side, the contact springs (15), supported in the frame (14), are arranged.

6. Modular control equipment according to one of the preceding claims, characterised in that the side walls of the frame (14) of the separators (9) are guided towards adjacent wall sections (18) of the frame blocks (1, 1') which are respectively formed by combined individual wall sections of the terminal pieces (3) of the terminal block (2).

7. Modular control equipment according to one of the preceding claims, characterised in that projecting guide segments (17) are provided on the lower side of the frame (14) of the separator (9), for which guide grooves (16) are formed in the frame block (1, 1') which are respectively formed by guide groove sections of the combined terminal pieces (3) of the terminal block (2).

8. Modular control equipment according to claims 2 and 4, characterised in that a latch spring (21), orientated towards the direction of movement and with a latching head, is provided on the separators (9), and in that the terminal pieces (3) of the terminal blocks (2) are each provided on their wall area adjacent to the latch spring (21) with a latching notch (19) for the latching head.

9. Modular control equipment according to claim 8, characterised in that a backward-facing projection is provided on the separator frame (14), on the underside of which the latch spring (21) is provided, which is aligned with the guide segments (17) on the underside of the frame (14).

10. Modular control equipment according to claim 8, characterised in that in addition to a section acting as a spring, the latch spring (21) has a section substantially corresponding to the guide segments (17).

11. Modular control equipment according to claim 9, characterised in that the projection (20) of the frame (14) is configured as an additional guide element and has the same lateral dimensions as the frame (14).

12. Modular control equipment according to one of the preceding claims, characterised in that a recess for the bus conductor section (8) is configured in the frame block (1, 1') of the terminal block (2, 2'), which is composed of lateral plug-in and locating grooves (23, 24) lying opposite one another, which respectively is formed by combination of corresponding plug-in and locating groove sections of the combined terminal pieces (3) of the terminal block (2).

13. Modular control equipment according to claims 3, 4 and 12, characterised in that the one plug-in and locating groove (24) is partially composed of spring segments (25) configured on the terminal pieces (3) of the terminal block (2), which are each provided with a latching head (26) in the area of the lateral limit of the groove (24). wherein in the relevant side of the bus conductor section (8) a latching notch (22) for cooperating with the latching head of one of the spring segments (25) is configured at a pre-determined point.

14. Modular control equipment according to one of the preceding claims, characterised in that the bus conductor sections (8) are provided with narrowed end areas (8a) upon which the separators (9) are movably arranged, wherein the transition from narrowed end section (8a) to bus conductor section (8) additionally forms a shoulder (8b) which defines the separating position/contacting position of the separator (9).

## Revendications

1. Système de commande modulaire, en particulier ensembles électroniques de commande et d'automatisation, comportant des blocs de boîtier (1, 1') dans lesquels sont respectivement disposées des sections de ligne de bus (8) d'une ligne bus interne, des éléments de connexion (9) déplaçables pour la jonction électrique des sections de ligne de bus (8) des blocs de boîtier (1, 1') adjacents, ainsi que des modules électriques (12, 12') qui peuvent être connectés mécaniquement avec les blocs de boîtier (1, 1') et électriquement avec les sections de ligne de bus (8), caractérisé en ce que les éléments de connexion sont des curseurs de coupure (9) autoporteurs, autonomes, présentant des contacts à ressort (15) supérieurs et inférieurs pour des pistes conductrices (10) prévues sur le côté supérieur et inférieur des sections de ligne de bus (8) et déplaçables par coulissement entre une position de connexion enserrant les sections terminales (8a) tournées l'une vers l'autre des sections de ligne de bus (8) des blocs de boîtier (1, 1') adjacents et une position de coupure coopérant avec seulement une section de ligne de bus (8).

2. Système de commande modulaire selon la revendication 1, caractérisé en ce que la position de connexion et la position de coupure des curseurs de coupure (9) sont des positions enclenchées.

3. Système de commande modulaire selon la revendication 1 ou 2, caractérisé en ce que les sections de ligne de bus (8) sont enclenchées dans leur position de montage dans les blocs de boîtier (1, 1').

4. Système de commande modulaire selon l'une des revendications précédentes, caractérisé en ce que les blocs de boîtier (1, 1') forment une zone partielle de blocs de jonction (2, 2') qui présentent des connexions de ligne d'alimentation et de ligne de signal (4 et 5) et se composent de plaques de jonction (3) individuelles.

5. Système de commande modulaire selon l'une des revendications précédentes, caractérisé en ce que les curseurs de coupure (9) possèdent un boîtier (14) qui présente un contour transversal fermé et dans lequel il est formé un passage pour les sections terminales (8a) des sections de ligne de bus (8) au contact desquelles sont disposés, sur le côté supérieur et le côté inférieur, les contacts à ressort (15) qui sont supportés par le boîtier (14).

6. Système de commande modulaire selon l'une des revendications précédentes, caractérisé en ce que les parois latérales du boîtier (14) des curseurs de coupure (9) sont guidées contre des sections de paroi (18) adjacentes des blocs de boîtier (1, 1') qui, le cas échéant, sont formées par des sections de paroi individuelles des plaques de jonction (3) alignées l'une à côté de l'autre et constituant les blocs de jonction (2).

7. Système de commande modulaire selon l'une des revendications précédentes, caractérisé en ce que sur le côté inférieur des boîtiers (14) des curseurs de coupure (9), sont prévues des nervures de guidage (17) formant saillie, pour lesquelles sont formées, dans les blocs de boîtier (1, 1'), des rainures de guidage (16) qui, le cas échéant, sont formées par des sections de rainure de guidage des plaques de jonction (3) groupées des blocs de jonction (2).

8. Système de commande modulaire selon les revendications 2 et 4, caractérisé en ce que sur les curseurs de coupure (9), il est prévu un cran d'arrêt élastique (21) orienté dans le sens de déplacement et présentant une tête encliquetable et en ce que les plaques de jonction (3) des blocs de jonction (2) présentent respectivement, dans leur zone de paroi adjacente au cran d'arrêt élastique (21), une encoche d'arrêt (19) pour la tête encliquetable.

9. Système de commande modulaire selon la revendication 8, caractérisé en ce que sur le boîtier (14) du curseur de coupure, il est prévu un appendice arrière (20) sur le côté inférieur duquel est prévu le cran d'arrêt élastique (21) qui se trouve sur le côté inférieur du boîtier (14), en position d'alignement par rapport aux nervures de guidage (17).

10. Système de commande modulaire selon la revendication 8, caractérisé en ce que le cran d'arrêt élastique (21) possède une section correspondant sensiblement aux nervures de guidage (17), en plus d'une section opérant comme un ressort.

11. Système de commande modulaire selon la revendication 9, caractérisé en ce que l'appendice (20) du boîtier (14) est réalisé comme élément de guidage supplémentaire et possède la même dimension latérale que le boîtier (14).

12. Système de commande modulaire selon l'une des revendications précédentes, caractérisé en ce que dans le bloc de boîtier (1, 1') des blocs de jonction (2, 2'), est formé un logement qui est destiné à la section de ligne de bus (8), qui résulte de rainures d'emboîtement et de logement (23, 24) latérales et opposées l'une à l'autre et qui, le cas échéant, est formé par l'alignement des sections correspondantes d'emboîtement et de logement des plaques de jonction (3) groupées des blocs de jonction (2).

13. Système de commande modulaire selon les revendications 3, 4 et 12, caractérisé en ce que l'une des rainures d'emboîtement et de logement (24) est formée en partie par des nervures élastiques (25) qui sont formées contre les plaques de jonction (3) des blocs de jonction (2) et présentent chacune une tête encliquetable (26) dans la zone de la limite latérale de la rainure (24), tandis que du côté concerné de la section de ligne de bus (8), à l'endroit prédéfini, une encoche d'arrêt (22) est formée pour la coopération avec la tête encliquetable de l'une des nervures à ressort (25).

14. Système de commande modulaire selon l'une des revendications précédentes, caractérisé en ce que les sections de ligne de bus (8) présentent des sections terminales (8a) rétrécies sur lesquelles les curseurs de coupure (9) sont montés coulissants, le passage de la section terminale (8a) rétrécie à la section de ligne de bus (8) formant par ailleurs un épaulement (8b) qui définit la position de coupure/position de connexion des curseurs de coupure (9).
